(19) Europäisches Patentamt

European Patent Office

Office européen des brevets

(11) **EP 1 039 310 A2**

## (12) EUROPÄISCHE PATENTANMELDUNG

(43) Veröffentlichungstag:
27.09.2000 Patentblatt 2000/39

(51) Int. Cl.7: **G01R 35/00**

(21) Anmeldenummer: **00103192.1**

(22) Anmeldetag: **17.02.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **26.03.1999 DE 19913722**

(71) Anmelder:
**Wavetek Wandel Goltermann Eningen GmbH & Co.**
**72800 Eningen u. A. (DE)**

(72) Erfinder: **Dickman, Norbert**
**41460 Neuss (DE)**

(74) Vertreter:
**Klocke, Peter, Dipl.-Ing.**
**Klocke - Späth**
**Patentanwälte**
**Kappelstrasse 8**
**72160 Horb (DE)**

### (54) Verfahren und Vorrichtung zum Prüfen eines Jittergenerators

(57) Verfahren zum Kalibrieren eines Jittergenerators, wobei die Linearität über die Bereiche der vom Jittergenerator erzeugten Jitteramplitude auf Nationale Normale rückführbar ist, bei dem ein rampenförmiges Modulationssignal (Sm) als Funktion der Zeit dem Jittergenerator zugeführt und aus der Frequenzverschiebung zwischen dem unmodulierten und dem vom Jittergenerator phasenmodulierten Ausgangssignal der Fehler des Jittergenerators in Abhängigkeit von der Steigung des Modulationssignals ermittelt wird. Die Anordnung zur Durchführung des Verfahrens umfaßt einen Funktionsgenerator zur Erzeugung eines Modulationssignals, der mit seinem Ausgang mit dem Eingang eines Jittergenerators verbunden ist und einem mit dem Ausgang des Jittergenerators verbunden Frequenzmesser zur Anzeige und Vergleich der Frequenzverschiebung. Die Erfindung stellt eine einfache Kalibrationsmethode zur Rückführung von Jitter auf Nationale Normale dar, wobei die prinzipbedingten Probleme und Nachteile der bisher bekannten Verfahren in bezug auf Aufwand, Flexibilität in der Wahl der Meßpunkte und Rückführbarkeit vermieden werden. Restriktionen in der Darstellung größerer Jitteramplituden werden durch die Erfindung aufgehoben.

Fig. 4

EP 1 039 310 A2

**Beschreibung**

Die Erfindung betrifft ein Verfahren und eine Vorrichtung zum Prüfen eines Jittergenerators, wie er aus der US 5 394 106 bekannt ist.

Die Qualität von Telekommunikationseinrichtungen wird unter anderem durch die sogenannte Jitterverträglichkeit des Systems gekennzeichnet. Unter Jitter werden dabei unregelmäßige Phasenschwankungen der verwendeten Trägerschwingungen im Telekommunikationsnetz bezeichnet. Insbesondere in größeren Telekommunikationsnetzen spielt die Reaktion auf Jitter eine zentrale Rolle. Zum Test der Reaktion von Netzelementen auf Jitter werden sogenannte Jittergeneratoren eingesetzt. Jittergeneratoren erzeugen abhängig vom Gerätetyp eine einstellbare Jitteramplitude von 0,1 bis ca. 200 Unit Intervall peak/peak (UIpp). Hierbei handelt es sich um eine Scheindimension ohne Einheit, die sich auf diesem Gebiet eingebürgert hat. Um den großen Bereich an geforderten Jitteramplituden erzeugen zu können, haben Jittergeneratoren häufig eine eingebaute Bereichsumschaltung. Mit diesem Jitter werden Telekommunikationseinrichtungen gezielt unter Stress gesetzt, um die Belastbarkeit der Systeme zu analysieren. Dabei werden hohe Anforderungen an die Linearität der Jittergeneratoren gestellt. Bei Prüfen der Linearität der Jittergeneratoren sollen möglichst nur Messwerte verwendet werden, die über alle Bereiche auf Nationale Normale rückführbar sind. Nur so ist eine exakte Beurteilung der Messwerte möglich, um so einen Abgleich der Jittergeneratoren durchführen zu können. Die Prüfung soll die Linearität auch für die größten erzeugbaren Jitteramplituden der Jittergeneratoren abdecken.

Bisher wird die Prüfung der Linearität und Absolutgenauigkeit von Jittergeneratoren nach der Besselmethode und der Überdeckungsmethode durchgeführt.

Bei der Besselmethode wird zur Modulation ein Sinussignal benutzt. Das modulierte Trägersignal wird einem Spektrumanalysator zugeführt. Die Modulation wird solange erhöht, bis Trägerunterdrückung eintritt. Nur an den diskreten Stellen bei 0,76xx; 1,75xx; 2,75xx; 3,75xx....X,75xx UIpp kommt es zur Trägerunterdrückung. Aus dem Unterschied der notwendigen Geräteeinstellung zur Erreichung der Trägerunterdrückung und der theoretischen Jitterhubeinstellung am Gerät lässt sich unter Annahme verzerrungsfreier Sinussignale, Störspektrumsfreiheit und strenger Linearität des Modulators die Messabweichung des Prüflings für diese Stützstellen berechnen. Schaltungsaufbau und Messdurchführung ist z. B. in "Service Manual PJM-4 Jitter Meter BN 2019", 1991, Kapitel 8, S. 12-14, der Firma Wandel & Goltermann GmbH & Co., D-72800 Eningen, beschrieben.

Nachteilig wirkt sich bei der Besselmethode die Empfindlichkeit auf Signalverzerrungen und Störlinien aus, da jede überlagerte Störung den Träger ebenfalls moduliert. Diese Effekte kommen aufgrund der begrenzten Trägereinheit, diskreter Störlinien, Nichtlinearitäten des Modulators und harmonischen Verzerrungen des Modulationssignals zu Stande. Diese unerwünschten Eigenschaften erzeugen zusätzliche Messfehler, die schwer quantifizierbar sind. Je größer die zu untersuchende Jitteramplitude ist, um so schwieriger wird es, überhaupt noch eine annehmbare Trägerunterdrückung zu erreichen. Unabhängig von diesen Effekten verhindert die vorgegebene diskrete Einstellmöglichkeit an realen Geräten die exakte Einstellung der korrekten Werte (Elemente der Menge der irrationalen Zahlen) zur Erreichung der Trägerunterdrückung. Hier springt unter Umständen das Ausgangsspektrum beim Inkrement der Jittereinstellung um den kleinstmöglichen am Gerät einstellbaren Wert über die sogenannte „Bessel-Null" hinweg. Ein Trägerunterdrückung im Spektrum ist aufgrund einer ständigen Wiederholung nicht eindeutig einen definierten Wert zuzuordnen. Anhand von realen Messungen wird diese Problematik der überlagerten Störungen offensichtlich, wobei der Einfluss auf die Trägermodulation in den Seitenlinien des Spektrums ebenfalls sichtbar wird. Deutlich erkennbar sind dabei auch überlagerte Störkomponenten nahe des Trägers. Das Spektrum ist mehrdeutig.

Bei der ebenfalls bisher angewandten Überdeckungsmethode wird auch zur Modulation ein Sinussignal benutzt. Das modulierte Signal wird auf einem Oszilloskop dargestellt, das auf einen unmodulierten Referenztakt triggert. Der Referenztakt wird entweder vom Prüfling zur Verfügung gestellt oder durch externe Messapparatur erzeugt. Die sich im Rhythmus der Modulation bewegende Phase des modulierten Signals kann so am Bildschirm beobachtet werden. Ausgewertet werden hierbei die zur Überdeckung kommenden Signalflanken. Zur Überdeckung kommt es bei allen Vielfachen der Modulation von 1,00 UIpp. Aus der am Oszilloskop abzulesenden Abweichung von der exakten Flankenüberdeckung lässt sich die Messabweichung des Prüflings berechnen. Die Überdeckungsmethode stützt sich auf eine visuelle Überprüfung am Oszilloskop, deren Ablesung von der subjektiven Einschätzung des Betrachters abhängt, da keine eindeutig umrissenen Linien sondern mehrfach überlagerte Strukturen abzulesen sind. So zeigen Darstellungen die mehrdeutige Messung des Jitterhubs nach der Überdeckungsmethode, durch verschwommene Überlagerungsbereiche, deren Breite ein Maß für die Abweichung der Modulation ist. Mit zunehmender Jitteramplitude wird die Ablesung wegen mehrfacher Überlagerung extrem erschwert oder unmöglich. Die Messung benötigt wegen der schwierig auszuwertenden Überlagerung zunehmenden Zeitaufwand bei größeren Modulationshüben. Eine Beschreibung hierzu findet sich in "Service Manual PFJ-8 Error and Jitter Test Set", 1991, Kapitel 8, S. 19-22, der Firma Wandel & Goltermann GmbH & Co., D-72800 Eningen.

Der Nachteil beider Verfahren ist, dass prinzipbedingt nur spezielle diskrete Stützstellen zur Verfügung stehen. Dies führt in jedem Fall zu einer unerwünschten Begrenzung der Anzahl möglicher Messpunkte. Die Fehler der Messanordnung sind schwer greifbar und ein Nationales Normal für die Ermittlung des Jitter ist nicht gegeben. Ein weiterer gemeinsamer Nachteil beider Verfahren liegt darin, dass sogar grobe Fehler im Prüfling mit den bekannten Methoden unentdeckt bleiben, da nach diesen Verfahren in der Auswertung kein definiertes Unterscheidungsmerkmal für eine Modulation der Größe n und (n+1) UIpp existiert.

Der vorliegenden Erfindung liegt daher die Aufgabe zugrunde, diese Probleme durch ein auf anderen Prinzipien beruhendes Verfahren zu umgehen und eine Möglichkeit vorzuschlagen, die eine rückführbare, eindeutige und schnelle Prüfung von Jittergeneratoren bei beliebigen Jitteramplituden ermöglicht und auch eine Anordnung zur Durchführung dieses Verfahrens umzusetzen.

Diese Aufgabe wird mit dem Verfahren nach dem Anspruch 1 gelöst. Weitere vorteilhafte Ausgestaltungen sind den diesbezüglichen Unteransprüchen zu entnehmen. Eine Lösung der Erfindung erfolgt außerdem durch eine Anordnung mit den Merkmalen gemäß dem Anspruch 4.

Gemäß dem beanspruchten Verfahren wird ein rampenförmiges Modulationstestsignal Sm als Funktion der Zeit dem Jittergenerator zugeführt und aus der Frequenzverschiebung zwischen dem unmodulierten und dem vom phasenmodulierten Ausgangssignal der Fehler des Jittergenerators in Abhängigkeit von der Steigung des Modulationssignals ermittelt.

Bei dieser, auch als Frequenzsprungverfahren bezeichneten Methode wird eine Trägermodulation derart erzeugt, dass mit einem Frequenzmesser unmittelbar die Stärke der Modulation abgelesen werden kann. Das nach diesem Verfahren modulierte Trägersignal erfährt für eine bestimmte Zeit einen eindeutigen Frequenzoffset, der dem Jitterhub proportional ist. Die Frequenz als Messgröße liegt unmittelbar als Nationales Normal vor. Somit kann ein Jittermodulator mit dem Frequenzsprungverfahren direkt rückführbar auf Nationale Normale geprüft werden.

Gemäß einer weiter bevorzugten Ausführungsform wird die Trägerfrequenz ohne Modulation als Bezugswert gespeichert, die Frequenz des modulierten Trägersignals nach der Modulation durch den Jittergenerator gemessen und aus dem Vergleich der Frequenzen die Messabweichung des Jittergenerators bestimmt.

Im Falle der Untersuchung von Signalen, deren Grundschwingung langsamer als die Taktfrequenz ist (z. B. subharmonischen Schwingungen) wird gemäß einer weiter bevorzugten Ausführungsform die Messabweichung mit einem Korrekturwert multipliziert, der sich aus dem Verhältnis der Grundfrequenz des untersuchten Signals und der Übertragungsrate der Taktfrequenz ergibt.

Die beanspruchte Anordnung zur Kalibrierung eines Jittergenerators umfasst einen Funktionsgenerator zur Erzeugung eines Modulationssignals, der mit seinem Ausgang mit dem Eingang eines Jittergenerators verbunden ist und einen mit dem Ausgang des Jittergenerators verbundenen Frequenzmesser zur Anzeige und Vergleich der Frequenzverschiebung.

Die Erfindung vermeidet somit die prinzipbedingten Nachteile der bisher üblichen Verfahren und weist folgende Vorteile auf:

1. Eindeutigkeit: Eine Modulation von n (n+1) UIpp wird nur mit dem Frequenzsprungverfahren eindeutig unterschieden.

2. Große Modulationshübe: Die Qualität der Modulationsauswertung bleibt bei größer werdender Modulation konstant und fällt nicht im Gegensatz zu den bekannten Methoden ab. Es gibt keine Restriktion bezüglich der Anwendbarkeit selbst größten Jitteramplituden.

3. Messgeschwindigkeit: Aufgrund der einfachen Geräteeinstellungen und der interpretationsfreien Ablesung des Ergebnisses ist dieses Verfahren extrem schnell. Es eignet sich aufgrund des einfachen Indikators besser zur Automatisierung als andere Verfahren. Die gewünschten Stützstellen können direkt eingestellt und gemessen werden, ohne die Notwendigkeit des Aufsuchens der Stelle, an dem sich der physikalische Indikator (z. B. Trägerunterdrückung, Überdeckung) offenbart. Dies spart Zeit.

4. Stützstellen: Die bei anderen Verfahren gegebene Limitierung auf prinzipbedingte Stützstellen entfällt. Das beanspruchte Verfahren ist bei beliebigen Jitteramplituden einsetzbar.

5. Störlinienempfindlichkeit: Das beanspruchte Verfahren ist unempfindlich gegen Störlinien im Spektrum, da das zu messende Signal über ein Zeitfenster (Torzeit des Frequenzmessers) gemittelt werden kann.

6. Rückführbarkeit: Die Auswertung geschieht über die diskret abzulesende Frequenz an einem Frequenzmesser. Subjektive, personenabhängige Aspekte der Auswertung entfallen. Die Rückführbarkeit über die unstrittige Relevanz des physikalischen Verfahrens (Transformation zwischen Zeit und Frequenzbereich) ist hergestellt.

Nachfolgend wird die Erfindung in Verbindung mit den Figuren näher erläutert. Es stellen dar:

Figur 1    eine schematische Darstellung der Frequenzverschiebung;

Figur 2    eine Rampenfunktion;

Figur 3    Anordnung zur Realisierung des Verfahrens zur rückführbaren quasi stationären Auswertung von Jitter und Analyse von Modulatorkennlinien; und

Figur 4    ein Beispiel einer lichtlinearen Modulatorkennlinie.

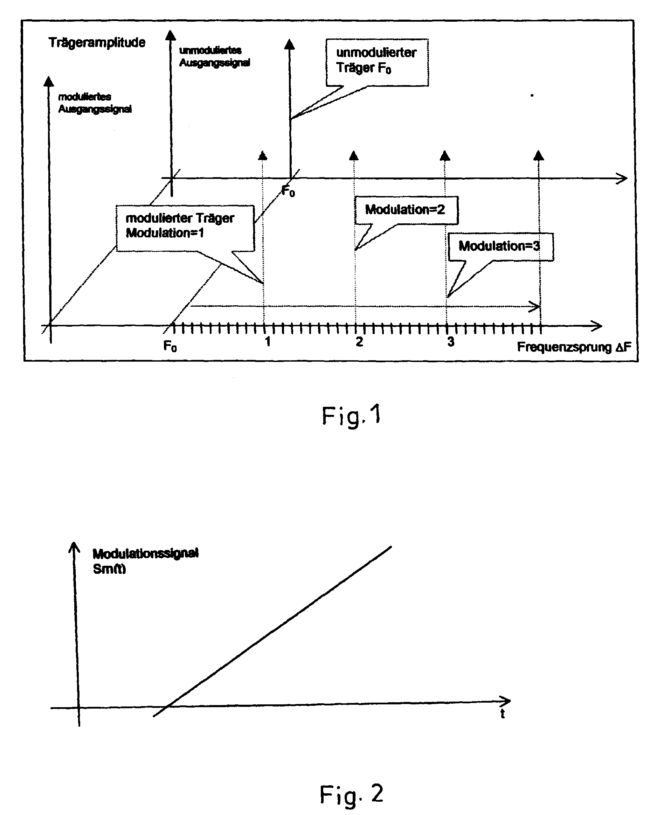

Aus der Figur 1 ist in einer schematischen Darstellung die eindeutige Frequenzverschiebung durch das jitterproportionale erfindungsgemäße Frequenzsprungverfahren ersichtlich. Durch die Charakteristik des Modulationssignals, das einen konstanten Frequenzoffset verursacht, lässt sich die Frequenzachse direkt in UIpp, der Pseudoeinheit des Jitters, skalieren. Mehrdeutigkeiten sind nicht möglich.

Die Grundgleichung für eine Phasenmodulation lautet allgemein:

$$\Psi(t) = \omega \times t + \alpha \times Sm(t) \qquad \qquad \text{Gl. 1}$$

Die Frequenzmodulation ergibt sich aus der Phasenmodulation durch Differenzierung

$$\Omega(t) = \omega_T + \alpha \times dSm(t)/dt \qquad \qquad \text{Gl. 2}$$

Üblicherweise wird in der Messtechnik mit Sinussignalen moduliert ($Sm(t) = Sin\Omega t$). Dies führt im Frequenzspektrum zu den bekannten Bessel-Spektren, die hier nicht weiter ausgeführt werden. Eine herausragende Eigenschaft lässt sich mit der hier zur Anwendung gelangenden Rampenfunktion anstelle des Sinussignals als Modulationssignal darstellen. Die Rampenfunktion mit der Gleichung

$$Sm(t) = k + S \times t \qquad \qquad \text{Gl. 3}$$

ist zusätzlich in der Figur 2 dargestellt. Für die Berechnung der Frequenzmodulation ergibt sich für die Rampenfunktion durch Differenzierung

$$dsm(t)/dt = d(k + s \times t)/dt = s \qquad \qquad \text{Gl. 4}$$

Durch Einsetzen von Gl. 4 in Gl. 2 ergibt sich

$$\Omega(t) = \omega_T + \alpha \times s \qquad \qquad \text{Gl. 5}$$

beziehungsweise mit $\Omega = 2\pi F$ von Kreisfrequenz auf Frequenz umgerechnet:

$$F(t) = F_0 + \Delta F \qquad \qquad \text{Gl. 6}$$

Das unmodulierte Trägersignal $F_0$ fährt also durch die beschriebene Modulation einen konstanten Frequenzoffset der Größe $\Delta F$.

Eine Modulation ($\Phi$) von 1,0 UIpp in einer Sekunde bedeutet eine Verschiebung der Frequenz um 1,0 Hz. Sie wird am Modulator durch eine Rampe erzeugt, die bei einer eingestellte Jitteramplitude von 1 UIpp innerhalb einer Sekunde den nominellen Eingangspegel (E) erreicht. Der erwartete Frequenzoffset ergibt sich danach allgemein zu:

$$\Delta F = \Phi \times s/E \qquad \qquad \text{Gl. 7}$$

mit $\Phi$=eingestellte Jitteramplitude/UIpp des Modulators, s=Steigung der Rampe in V/s und E=nominelle Eingangsamplitude des Modulators in V.

Durch den differenziellen Zusammenhang zwischen der Frequenzmodulation und der Phasenmodulation wird die Ausgangsfrequenz des modulierten Trägers bei Verwendung des rampenförmigen Modulationssignals konstant (vgl. Gl. 6). Das Verfahren macht sich diese besondere Eigenschaft zu Nutze. Der konstante Frequenzoffset des Trägers wird mit einem Frequenzmesser direkt in Hz gemessen. Dazu wird im ersten Schritt die Trägerfrequenz ohne Modulation gemessen und als Bezugswert gespeichert. Danach wird die Trägerfrequenz bei eingeschalteter Modulation unter Benutzung des rampenförmigen Modulationssignals gemessen und die Differenz beider Frequenzen gebildet. Die Differenzbildung läßt sich komfortabel durch die in heutige Frequenzmesser eingebauten Funktionen automatisch realisieren. Durch Vergleich des gemessenen Frequenzoffsets mit dem erwarteten Frequenzoffset wird die Messabweichung des Prüflings, d. h. die Abweichung von einem linearen Zusammenhang zwischen der Rampensteigung s und der Frequenzverschiebung ∆F bestimmt.

Der vorstehend beschriebene Zusammenhang gilt für den Frequenzoffset der Trägerfrequenz (Takt). Im Falle der Untersuchung von Datensignalen, die nur ein Bruchteil des Taktes aufweisen und somit deren Grundschwingung langsamer als die Taktfrequenz ist, wird ein linearer Korrekturwert $F_{Sig}/F_B$ resultierend aus dem proportionalen Zusammenhang zwischen Jitterhub und Trägerfrequenz-Periodendauer angesetzt:

$$\Delta F = \Phi \times s/E \times F_{Sig}/F_B \qquad \qquad \text{Gl. 8}$$

mit $F_{Sig}$ als Grundfrequenz des untersuchten Signals und $F_B$ als Übertragungsrate.

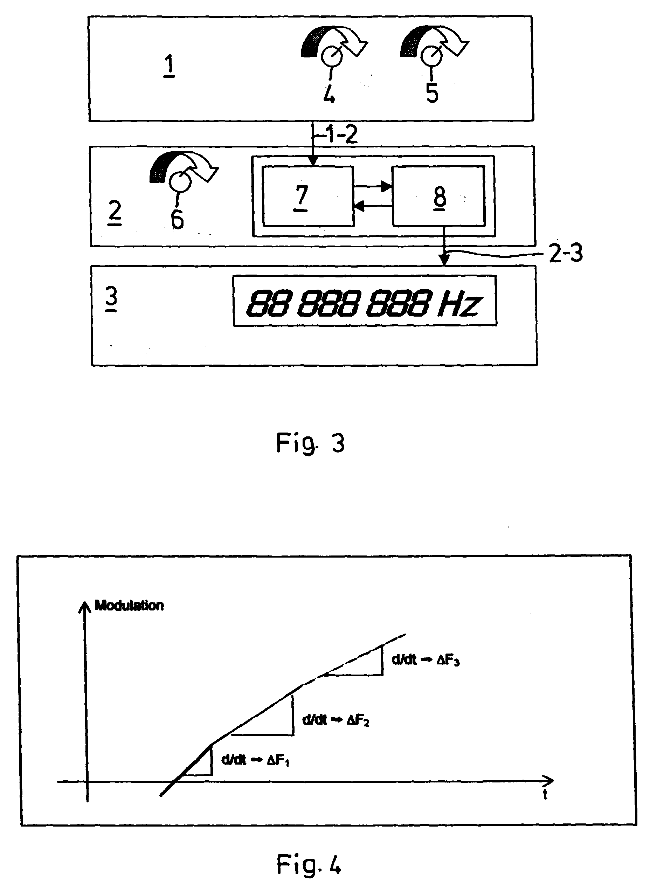

Bei der in Figur 3 dargestellten Anordnung zur Durchführung des beanspruchten Verfahrens wird ein Funktionsgenerator 1 zur Erzeugung der Modulationsspannung mit dem Prüfling 2 (Jittergenerator) über die Leitung 1-2 verbunden. Das Ausgangssignal des Prüflings 2 wird über die Leitung 2-3 einem Frequenzmesser 3 zugeführt Der abgelesene Frequenzoffset gegenüber dem unmodulierten Signal entspricht direkt der tatsächlichen Modulation durch den Prüfling. Die prozentuale Abweichung zwischen dem erwarteten theoretischen Frequenz-Sollwert und dem realen Frequenz-Messwert entspricht direkt nach Betrag und Vorzeichen dem prozentualen Fehler des Prüflings. In der Figur ist mit der Bezugsziffer 4 der Einstellknopf für die Amplitude und mit der Bezugsziffer 5 der Einstellknopf für die Periode am Funktionsgenerator 1 bezeichnet. Entsprechend kann mit dem Einstellknopf 6 am Jittergenerator 2 die Jitteramplitude eingestellt werden. In der schematischen Darstellung ist der Phasenmodulator 7 und der Taktgenerator 8 des Jittergenerators 2 als Funktionsblock gezeigt.

Durch geeignete Veränderungen der Einstellungen des Funktionsgenerators 1 und des Jittergenerators 2 kann der gesamte Linearitätsbereich des Prüflings (Figur 4) untersucht und kalibriert werden. Aufgrund der linearen Zusammenhänge zwischen Jitterhub und Frequenzoffset bei diesem Verfahren lassen sich für jeden Prüfling immer passende Einstellparameter-Kombinationen finden, die der jeweils eingesetzten Technik Rechnung tragen (z. B. Einstellbereiche, automatische geschaltete Dämpfungsglieder etc.) und so eine lückenlose und eindeutige Kalibrierung des Prüflings ermöglichen. In einem experimentellen Versuchsaufbau wurde ein Frequenzmesser Fluke 6685 R, ein arbiträrer Funktionsgenerator Typ AWG 2021 von Tektronix und ein Jittermessplatz PF-J-8 von Wandel & Goltermann benutzt. Folgende Parameter wurden eingestellt:

Funktionsgenerator (1)

| Signalform | Rampe |
|---|---|
| Amplitude A | 1,0 Volt |
| Periode T | 1,0 s |

Jittergenerator (2)

| Bitrate | 2.048 Mbit/s |
|---|---|
| Signalmuster | AIS |
| Leitungscode | HDB-3 |
| Jitterhub Φ | 10,0 UIpp |
| Nominelle Modulator-Eingangsamplitude E | 1,0 Volt |

Frequenzmesser 3

| Display | $F-F_0$ |
|---|---|
| $F_0$ | $2.048 \times 10^6$ Hz |
| Measuring Time | 0,5 Sekunden |

AIS steht für Alarm Indicating Signal, welches ein typisches Signal aus der Telekommunikation ist und nur aus den Ziffern „1" besteht. Es ist ein sehr kontinuierliches Signal und eignet sich für eine derartige Messung besonders gut. HDB-3 steht für High Dentity Bipolar of Order 3, welches ebenfalls ein typischer Code in der Telekommunikation darstellt.

Der Frequenzmesser 3 zieht bei der vorgegebenen Einstellung automatisch die Frequenz des unmodulierten Trägers des zu untersuchenden Signals ab. Die Eingabe der Sollfrequenz kann auch durch automatische Bezugsmessung der unmodulierten Trägerfrequenz geschehen. Dadurch entfällt für die Fehlerrechnung der Eigenfehler des Frequenzmesser 3 bei gleichzeitiger Eliminierung des Eigen-Offset von Frequenzzähler 3 und Jittergenerator 2.

In dem Beispiel ergibt sich mit Gl. 9 der erwartete Frequenzoffset am Taktausgang durch Einsetzen der Einstellparameter in Gl. 7 zu

$$\Delta F = 10{,}0\,UIpp \times 1V/1s \times 1/1V = 10.0/s$$

Der Sollwert Frequenzoffset beträgt $\Delta F = 10{,}0$ Hz. Ein beispielhafter Istwert $\Delta F = 10{,}4$ Hz, worauf sich ein Fehler des Prüflings mit Istwert - Sollwert = +0,4 Hz= +4% ergibt. Am Signalausgang ergibt sich entsprechend mit $F_{Sig}$ = 1024 kHz = $F_B/2$ (bei AIS) nach Gl. 8

$$\Delta F = 10{,}0\,UIpp \times 1V/1s \times 1/1V \times 1024\ kHz/2048\ kHz = 5{,}0/s$$

Dies ergibt bei einem Sollwert für Frequenzoffsets von $\Delta F = 5{,}0$ Hz und einem beispielhaften Istwert von $\Delta F$ = 5,2 Hz den Fehler des Prüflings Istwert - Sollwert = +0,2 Hz = +4 %.

Zur Prüfung der Linearität des Modulators können nun alternativ oder in Kombination folgende Parameter beliebig variiert und damit nach Gl. 7 alle gewünschten Jitteramplituden, wie Amplitude A des Funktionsgenerators 1, Rahmenanstiegzeit T des Funktionsgenerators 1 und Jitterhubeinstellung Φ des Jittergenerators 2 erzeugt werden. Der erwartete Frequenzoffset verhält sich immer proportional zur vorgenommenen Parameteränderung.

Die dynamische Aussteuerung ist bei diesem Verfahren konstant. Dies bedeutet, dass die Phasenänderungsgeschwindigkeit anders als bei einer sinusförmigen Modulation konstant ist ( d/dT = C ). Daher ist der Modulator in der Frequenzebene konstant ausgesteuert. Diese Eigenschaft erlaubt, die Jitterlinearität sogar aus einem Augenblickswert zu ermitteln, wie in Figur 4 gezeigt. Eine besondere Stärke des Verfahrens liegt darin, dass zur Analyse von Modulatorkennlinien die Linearität einzelner Modulatorkennlinienabschnitte in Abhängigkeit von der Aussteuerung geprüft werden kann. Da der Frequenzoffset bei diesem Verfahren zu jedem Zeitpunkt konstant ist, bildet die mehrfache Messung die gekrümmte Kennlinie des Modulators als Funktion des Jitterhubs ab und kann sofort in der Frequenzebene abgelesen werden. In der Figur 4 ist ein Beispiel einer nichtlinearen Modulatorkennlinie dargestellt, das mit Mehrfachmessung nach dem Frequenzsprungverfahren gemäß der Erfindung ausgemessen wurde. Die gekrümmte Kennlinie bildet sich an den einzelnen messbaren Kennlinienabschnitten ab.

## Patentansprüche

1. Verfahren zum Prüfen eines Jittergenerators, hinsichtlich der Linearität der Beziehung zwischen dem Modulationssignal und der vom Jittergenerator erzeugten Jitteramplitude bei dem rampenförmige Modulationstestsignale (Sm) mit konstanter Steigung als Funktion der Zeit dem Jittergenerator (2) zugeführt werden, die zu entsprechenden Frequenzverschiebungen zwischen dem unmodulierten und dem vom Jittergenerator (2) phasenmodulierten Ausgangssignal führen, bei dem diese Frequenzverschiebungen in Abhängigkeit von der Steigung des Modulationssignals (Sm) mit einem Frequenzmesser (3) gemessen werden und bei dem die Linearität des gemessenen Zusammenhangs für die Beurteilung des Jittergenerators herangezogen wird.

2. Verfahren nach Anspruch 1, **dadurch gekennzeichnet**, dass die Trägerfrequenz ohne Modulation als Bezugswert gespeichert, anschließend die Frequenz des Modulationstestsignals (Sm) nach der Modulation durch den Jittergenerator (2) gemessen und dann aus der Differenz der Frequenzen die Jitteramplitude des Jittergenerators (2) bestimmt wird.

3. Verfahren nach Anspruch 2, **dadurch gekennzeichnet**, dass die Differenz der Frequenzen mit dem Verhältnis der Grundfrequenz des untersuchten Signals und der Übertragungsrate der Taktfrequenz multipliziert wird.

4. Anordnung zur Durchführung des Verfahrens nach Anspruch 1, gekennzeichnet durch einen Funktionsgenerator (1) zur Erzeugung rampenförmiger Modulationstestsignale, der mit seinem Ausgang mit dem Eingang des zu prüfenden Jittergenerators (2) verbunden ist, und durch einen mit dem Ausgang des Jittergenerators (2) verbunden Frequenzmesser (3) zur Anzeige von Frequenzverschiebungen durch die Modulationstestsignale.

Fig. 1

Fig. 2

Fig. 3

Fig. 4